# NEW EUROPEAN PATENT SPECIFICATION

(11) **EP 0 199 293 B2**
(45) Date of publication and mention of the opposition decision: **30.08.1995**
(45) Mention of the grant of the patent: 27.02.1991
(21) Application number: 86105333.8
(22) Date of filing: 17.04.1986
(51) Int. Cl.: H01L 29/74, H01L 29/78, H01L 29/36, H01L 27/06

(54) **Insulated gate semiconductor device**
Halbleiteranordnung mit isoliertem Gate
Dispositif semi-conducteur à grille isolée

(30) Priority: 24.04.1985 US 726749
(43) Date of publication of application: 29.10.1986
(73) Proprietor: GENERAL ELECTRIC COMPANY, Schenectady New York 12305 (US)
(72) Inventor: Baliga, Bantval Jayant, Schenectady New York 12309 (US); Chow, Tat-Sing Paul, Schenectady New York 12309 (US); Temple, Victor Albert Keith, Jonesville New York 12065 (US)
(74) Representative: Bergen, Klaus, Dipl.-Ing.

(56) References cited:
- EP-A- 0 091 094
- DE-C- 2 904 424
- DE-C- 2 915 885
- GB-A- 2 062 349
- GB-A- 2 072 422
- GB-A- 2 088 631
- US-A- 123 936
- PATENT ABSTRACTS OF JAPAN, vol. 10, no. 27, (E-378)[2084], 4th February 1986 & JP-A-60-186 068

## Description

The present invention relates in general to semiconductor devices and in particular to insulated gate devices of the type including inherent bipolar transistors.

### Background of the Invention

A typical insulated gate device is the insulated-gate transistor (IGT), a device capable of controlling relatively high levels of forward current with a relatively low bias voltage applied to its gate electrode. As such, IGTs find many applications in the fields of power generation and power control.

A typical IGT comprises four adjacent semiconductor regions of alternate conductivity types (eg. a PNPN structure) which may be considered to form a pair of inherent bipolar transistors that are regeneratively coupled to form an inherent thyristor. The operating characteristics of these inherent bipolar transistors impose certain limitations on the operation of the device. Specifically, when a threshold forward current level is exceeded in the IGT device, its inherent thyristor latches into an "on" or conducting state, and control of the forward current through biasing of the gate electrode (i.e. gate control) is lost. When such a loss of gate control occurs, actions external to the device must be taken to limit or stop the forward current flow, and thereby possibly even avoid destruction of the device.

Analysis of the operation of the inherent bipolar transistors reveals the physical mechanism which causes the IGT to latch on and subsequently lose gate control. In an IGT with a P-conductivity type base region, an increase in the level of the forward electron current flow causes an increase in the level of a parasitic hole current in the base region, which in turn causes a lateral voltage drop along the base region adjacent an emitter-base junction. When this lateral voltage drop exceeds the inherent emitter-base junction potential, bipolar action is initiated at this junction, i.e. the emitter commences injection of current carriers across the emitter-base junction, and the forward current gain of an associated, inherent bipolar transistor increases. In a manner well known in the art, when the sum of the forward current gains of the pair of regeneratively coupled, inherent bipolar transistors approaches unity, the inherent thyristor latches on, causing the loss of gate control described above.

Another type of insulated gate device is the insulated-gate field-effect transistor (IGFET), commonly referred to as a metal-oxide-semiconductor field-effect transistor (MOSFET). In a manner similar to the IGT, the IGFET can also gate control high levels of forward current with a relatively low bias voltage. The IGFET device includes a single. inherent bipolar transistor susceptible to being biased into conduction, whereupon gate control of the forward current is lost. An insulated gate semiconductor device according to the preamble of claim 1 is known from EP-A-0091094. In this prior art, one of the base regions includes two portions in order to reduce the latching risk. One of these portions is doped substantially higher in concentration than the other to reduce its resistance to holes and it comprises a deeper diffused region than the other portion. The doping concentration of the emitter region is to be greater than 10¹⁹ atoms/cm³.

### Objects of the Invention

It is a principal object of the present invention to provide a new and improved insulated gate semiconductor device which is not subject to the aforementioned problems and disadvantages.

Another object of the present invention is to provide an insulated gate semiconductor device which includes an inherent bipolar transistor having a reduced tendency to initiate bipolar action at a selected junction.

A further object of the present invention is to provide an insulated gate transistor capable of reliably controlling a high forward current.

### Summary of the Invention

As defined in the claims, the foregoing objects of the invention are achieved through the use of a new and improved insulated gate semiconductor device which includes an inherent bipolar transistor having an emitter region which is relatively lightly doped in comparison to prior art practice. It has been discovered that, by lightly doping the emitter region in accordance with the present invention, the operating characteristics of the inherent bipolar transistor are altered so as to accommodate unexpectedly large increases in the levels of controllable forward current flow through the insulated gate device, thus enhancing its adaptability to power switching applications.

An embodiment of the invention as implemented in an IGT device includes, in a silicon semiconductor wafer; a collector region, a drift region adjoining the collector region, a base region adjoining the drift region, and an emitter region adjoining the base region and forming an emitter-base junction therewith. A gate electrode is insulatingly spaced from the base region. The emitter, base and drift regions together constitute a first inherent bipolar transistor, while the collector, drift and base regions together constitute a second inherent bipolar transistor. By the nature of their construction, these first and second transistors are regeneratively coupled to form an inherent thyristor, the thyristor being susceptible to latching on in the manner described above.

In accordance with the present invention, the IGT semiconductor emitter region is lightly doped with impurities to a surface dopant concentration level (i.e. dopant atoms/cm³ at the semiconductor surface) of between 10¹⁷ and 10¹⁹ dopant atoms/cm³ and not greater than one hundred and fifty times higher than the surface dopant concentration level of the semiconductor base region. This light doping decreases the injection efficiency of the emitter region, which has the effect of suppressing bipolar action at the emitter-base junction until a substantially increased threshold level of forward current is exceeded, thus suppressing the concomitant increase in the forward current gain of the first inherent bipolar transistor. Hence, the sum of the forward current gains of the inherent bipolar transistor pair is maintained below unity, preventing the thyristor from latching on, even at previously uncontrollable forward current levels. Thus, the IGT device is capable of conducting increased levels of controllable forward current.

As will be discussed in detail below, the beneficial effects obtained by lightly doping the emitter regions of the IGT and IGFET devices are enhanced by decreasing the depths of those regions.

### Brief Description of the Drawings

While the specification concludes with claims defining the features of the invention that are regarded as novel, it is believed that the invention, together with further objects thereof, will be better understood from a consideration of the following description in conjunction with the drawing Figures in which:
Figure 1 is a cross-sectional view of an insulated gate transistor constructed in accordance with the present invention as claimed
Figure 2 is a schematic electrical circuit representation of the insulated gate transistor of Figure 1;
Figure 3 is a graph illustrating the dopant concentration profiles of the regions of the insulated gate transistor of Figure 1, including the profile of the emitter region doped in accordance with the s present invention;
Figure 4 is a graph illustrating the dopant concentration profile of an alternative embodiment of the invention; and
Figure 5 is a schematic. electrical circuit representation of an insulated gate field effect transistor included for explanation but not forming part of the invention as claimed.

### Detailed Description

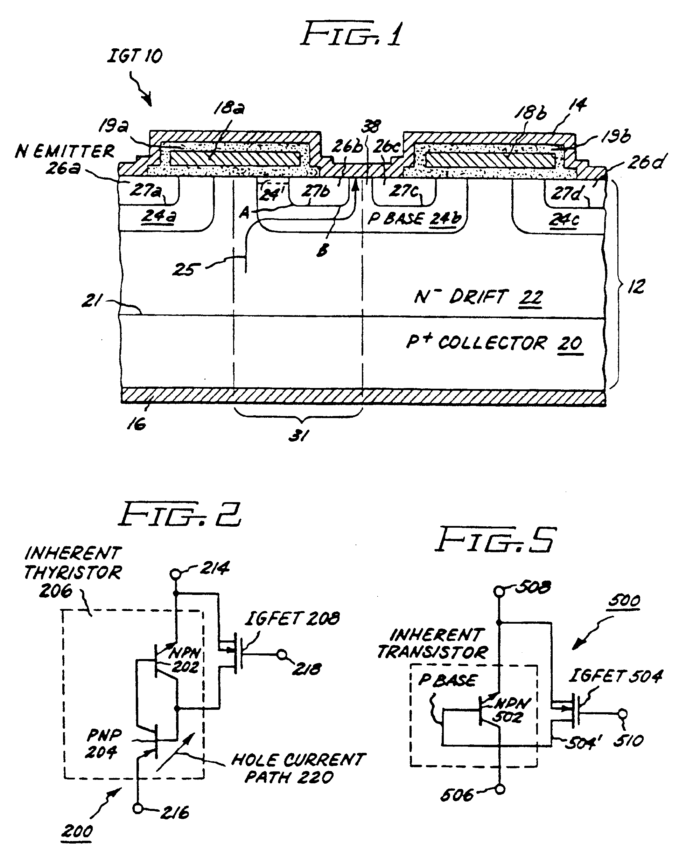

Referring now to the drawings, Figure 1 shows a representative portion of an insulated gate transistor (IGT) 10 including a silicon semiconductor wafer 12 comprising adjoining semiconductor regions of alternate conductivity types. An N- (i.e. lightly doped. N-conductivity type) drift layer 22 overlies a P + (i.e. highly doped, p-conductivity type) collector layer 20. Three p (i.e. moderately doped. P-conductivity type) base regions, 24a, 24b and 24c, overlie the drift region, and are in turn overlain by four emitter regions indicated at 26a - 26d. In accordance with the present invention, the emitter regions are of a relatively lightly doped N-conductivity type as described in detail below Drift and collector regions 22 and 20, respectively, form a P-N, drift-collector junction 21, while the overlying base and emitter regions form four P-N, base-emitter junctions, indicated respectively at 27a, 27b, 27c and 27d. A collector electrode 16 contacts collector region 20, and an emitter electrode 14 contacts portions of the base and emitter regions. Two gate electrodes, 18a and 18b, preferably comprising highly doped polysilicon and being interconnected at a selected location in IGT 10 (not shown), are insulatingly spaced from portions of the base, emitter and drift regions by a pair of insulating regions 19a and 19b, respectively.

It will be appreciated that the vertical section of IGT 10 indicated above bracket 31 constitutes a cell including emitter region 26b, a portion of base region 24b and portions of drift and collector regions 22 and 20, respectively, and that this cell structure is substantially identically repeated throughout the horizontal length of the IGT (as viewed in Figure 1). The operation of the IGT will, therefore, be described with respect to the single vertical cell indicated by the bracket 31′, all cells typically operating in a similar manner.

In operation, a positive bias voltage is applied to gate electrode 18a to establish an electrical field in wafer 12. When the bias voltage and hence the electrical field exceeds a predetermined threshold, an inversion layer of electrons is formed in portion 24′ of base region 24b. Inversion layer 24′ thus establishes an electron path through the base region, allowing electrons from emitter region 26b to flow laterally through the base region to drift region 22. Concurrently, drift-collector junction 21 is biased above its inherent potential, causing collector layer 20 to inject hole current carriers (not shown) into drift layer 22 which recombine with the electrons (not shown) from emitter layer 26b. A forward current path is thereby established between emitter electrode 14 and collector electrode 16, gate control of the forward current flow being accomplished by regulating the magnitude of the bias voltage applied to gate electrode 18a.

While most of the hole current carriers injected from collector region 20 into drift region 22 recombine with electrons, a portion of these carriers flow along the path designated by arrow 25 to the portion of emitter electrode 14 adjacent a portion 38 of base region 24b. The hole current in path 25 causes a lateral voltage drop to develop in base region 24b along emitter-base junction 27b, between the points designated A and B. When this lateral voltage drop exceeds the inherent junction potential (i.e. approximately 0.7V for silicon), bipolar action is initiated across this junction (i.e. emitter electrons are injected into the base region). As will be described in detail below, this bipolar action causes an inherent thyristor to latch on, resulting in a loss of gate control of the forward current.

A more thorough understanding of the cause of the thyristor latching action of IGT 10 can be had through a consideration of the equivalent bipolar transistor model shown in electrical circuit 200 of Figure 2 and the relationship of this circuit to the physical structure of IGT 10 of Figure 1. Equating the model to the IGT structure of Figure 1, it can be seen that the adjoining portions of emitter region 26b, base region 24b and drift region 22 form an NPN bipolar transistor 202. In a similar manner, the adjoining portions of base region 24b, drift region 22 and collector region 20 form a PNP bipolar transistor 204. By the nature of their structure, these two bipolar transistors are regeneratively coupled to form an inherent thyristor 206. The electrical circuit further includes an IGFET 208, which corresponds to the insulated gate electrode 18a and the underlying emitter, base and drift regions of IGT 10. Emitter, gate and collector electrodes, indicated respectively at 214, 218 and 216 of Figure 2, correspond to emitter, gate and collector electrodes 14, 18a and 16, respectively, of IGT 10 in Figure 1.

In operation, the magnitude of the bias voltage applied to gate electrode 218 controls the magnitude of the forward electron current flow between emitter electrode 214 and collector electrode 216, i.e. the current flow through the inherent thyristor 206. As described above, this forward current flow causes an increase in the hole current flow, indicated by arrow 220, which forward biases the emitter-base junction 27b (Figure 1) and initiates bipolar action thereat. This bipolar action causes a fast and substantial increase in the forward current gain of NPN transistor 202. As described above, when the sum of the forward current gains of transistors 202 and 204 approaches unity, inherent thyristor 206 will latch on and gate control of the forward current is lost.

In accordance with the present invention, the bipolar action at the emitter-base junction is suppressed, and hence the forward current gain of transistor 202 is maintained low, by relatively light doping of emitter region 26b of Figure 1 in comparison to prior art practice. This light doping of the emitter region decreases its injection efficiency, which also has the effect of slightly increasing the resistance of the emitter region to the forward, electron current flow. Thus, the lateral voltage drop developed in the emitter region adjacent emitter-base junction 27b (of Figure 1) due to the forward electron current flow is slightly higher than the potential developed in emitter regions doped in accordance with the prior art. Accordingly, a higher hole current flow is then necessary to create in the base region a lateral voltage drop sufficient to forward bias the junction. In summary, when the emitter region is lightly doped in accordance with the present invention, bipolar action at the emitter-base junction does not occur until an increased threshold of forward current is exceeded, the forward current gain of the NPN transistor is accordingly maintained low, and latch on of the thyristor is suppressed to a greater extent than is found in the prior art.

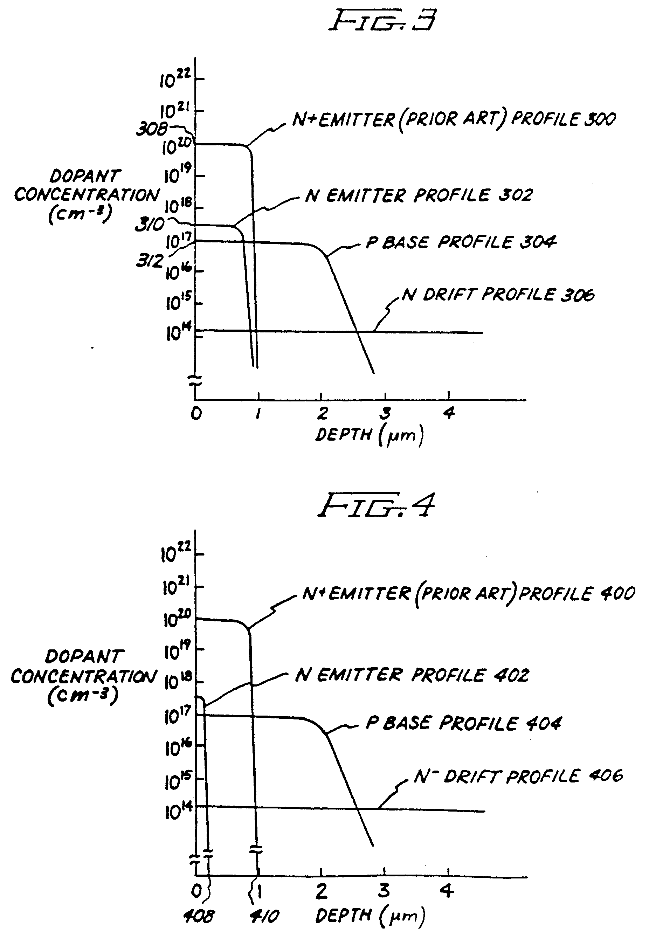

Figure 3 illustrates typical dopant concentration profiles for the various regions of the IGT, including a base region profile 304, a drift region profile 306, and first and second emitter region profiles 300 and 302, respectively. The first emitter region profile 300 illustrates an emitter region doped in accordance with the prior art and includes a surface dopant concentration, indicated at 308, of 10²⁰ dopant atoms per cubic centimeter (the surface dopant concentration being measured at the respective region surfaces closest to emitter electrode 14). The second emitter region profile 302 illustrates a relatively lightly doped emitter region in accordance with the present invention. profile 302 is seen to have a surface dopant concentration indicated at 310, of 5x10¹⁷ dopant atoms per cubic centimeter, a value of only five times that of the surface dopant concentration of base region profile 304, indicated at 312. Comparatively, the surface dopant concentration of prior art profile 300 is three orders of magnitude higher than the surface dopant concentration of the base region.

Experimentation has shown that. for a typical IGT device having a base region doped to a surface concentration of 10¹⁷ dopant atoms per cubic centimeter, when the emitter region is doped to a surface concentration of 7x10¹⁹ dopant atoms per cubic centimeter, a concentration only slightly less than that of the prior art (i.e. 10²⁰ dopant atoms per cubic centimeter), the level of forward current required to latch on the inherent thyristor is, unexpectedly, significantly increased by about a factor of two. Theoretical calculations predict that when the emitter region surface dopant concentration is maintained at not greater than one hundred and fifty times higher than the base region surface dopant concentration, an even more significant increase in the level of gate controllable forward current will be achieved. A further, practical limitation sets the lower limit of the emitter region surface dopant concentration at that value necessary to establish ohmic contact between the emitter region and emitter electrode 14.

Figure 4 shows an alternate embodiment of the invention having (prior art) emitter, base and drift region dopant concentration profiles indicated at 400, 404 and 406, respectively, which are identical to the (prior art) emitter, base and drift region dopant concentration profiles of Figure 3. The emitter region profile. indicated at 402, is lightly doped in the manner described above, and, further, is doped to considerably less depth as compared to prior art practice, the depth of the region being measured vertically downward from the region surface closest to emitter electrode 14. As indicated at 408, the emitter region of this alternate embodiment of the invention is doped to a depth substantially less than the approximately 1 micron depth of the prior art profile indicated at 410. With the emitter region lightly doped to a shallow depth. hole current carriers which travel along path 25 of Figure 1 are injected from P base region 24b into emitter region 26b, and are transported through the emitter region to recombine at its surface. This hole current injection has the effect of further decreasing both the injection efficiency of the emitter region and the level of the hole current flow, both of which have the net effect of increasing the level of controllable forward current in the IGT, as described above.

The principles of the present invention are also applicable to IGFET devices for preventing a loss of gate control of a forward electron current flow. A typical IGFET structure (not shown) is substantially identical to the IGT structure of Figure 1, with the exception that an N + drain region is substituted for p + collector region 20. The emitter, base and drift regions of the IGT of Figure 1 correspond to source, body and drift regions, respectively, of an IGFET. Similarly, the emitter, gate and collector electrodes of the IGT correspond to source, gate and drain electrodes, respectively, of an IGFET. There being no P + collector region to initiate a hole currant flow in the body region of an IGFET, the flow is initiated due to thermal generation caused by increases in the IGFET source-drain voltage. Such an IGFET structure does not fall within the scope of the invention as claimed.

Figure 5 shows an electrical circuit 500 representation of an IGFET semiconductor device, including an inherent NPN bipolar transistor 502 and an IGFET 504. Relating the circuit to the structure illustrated in Figure 1 (with exception of the substitution of a drain region for the collector region as described above), it is seen that the emitter, base and drift regions which comprise transistor 202 of Figure 2 above, also comprise NPN transistor 502. Similarly, IGFET 504 represents the sarne structure as IGFET 208 of Figure 2 above. Three electrodes. indicated at 506, 508 and 510, represent drain, source and gate electrodes, respectively, which correspond to the collector, emitter and gate electrodes, respectively. of Figure 1. By lightly doping the source region of an IGFET (comparable to region 26b in the device of Figure 1), bipolar action at a source-body junction is suppressed in a manner substantially identical to the suppression of bipolar action at the emitter-base junction described above, and conduction of inherent bipolar transistor 502 is suppressed. Accordingly, loss of gate control of the forward current is avoided for higher levels of forward current than has heretofore been possible.

It will be appreciated that while two dopant concentration profiles are described and illustrated in the embodiments of the invention set out above, the exact profile can vary in quantity and distribution within the limits described. Various methods of doping will, of course, yield different dopant profiles. It will be further appreciated that, while decreasing the surface dopant concentration level of the emitter region in accordance with the present invention will increase the gate controllable forward current level of the insulated gate devices in the manner described herein. this decrease has the further effect of increasing the forward voltage drop across the devices. Accordingly. the surface dopant concentration may be varied within the limits described herein to provide both an increase in the gate controllable forward current level and a forward voltage drop of an acceptable magnitude, the acceptable magnitude of a forward voltage drop being determined by the particular application of a device.

While semiconductor regions of specific conductivity types are described above, the invention is equally applicable to insulated gate devices having complementary semiconductor regions, i.e. where the P and N type regions are reversed in conductivity type.

## Claims

1. An insulated gate transistor having two inherent bipolar transistors, the transistors being regeneratively coupled to form an inherent thyristor, said insulated gate transistor comprising in a silicon semiconductor wafer (12):
a semiconductor drift region (22) of a first conductivity type;
a semiconductor base region (24b) of a second conductivity type opposite to said first conductivity type, said base region adjoining said drift region on one side and
a collector region (20) of said second conductivity type adjoining said drift region on an opposing side;
a semiconductor emitter region (26b) of said first conductivity type adjoining said base region; and a gate electrode (18a) insulatingly spaced from said base region and conductively coupling said drift region to said emitter region by an inversion layer (24′) formed in said base region in response to an appropriate applied bias;
the emitter, base and drift regions together constitute a first inherent bipolar transistor, while the collector, drift and base regions together constitute a second inherent bipolar transistor;
characterised in that
said emitter region has a surface dopant concentration of between 10¹⁷ and 10¹⁹ dopant atoms per cubic centimetre and not greater than one hundred and fifty times higher than the surface dopant concentration of said base region, such as to inhibit a latch-on effect of the inherent thyristor.

2. An insulated gate transistor as in Claim 1 wherein:
said surface dopant concentration of said emitter region is sufficient to establish an ohmic contact between said emitter region and an emitter electrode (14) contacting said emitter region.

3. An insulated gate transistor as in Claim 1 or 2 further including:
a collector electrode (16) contacting said collector region (20) of said second conductivity type adjoining said drift region.

4. An insulated gate transistor as in Claim 1, 2 or 3 wherein:
said base, emitter and drift regions form a first surface in said insulated gate transistor with said emitter region extending into said base region and being less that 1 »m in depth.

## Patentansprüche

1. Isolier-Gate-Transistor mit zwei inhärenten bipolaren Transistoren, die regenerativ zum Bilden eines inhärenten Thyristors gekoppelt sind, wobei der Isolier-Gate-Transistor in einer Silizium-Halbleiterscheibe (12) umfaßt:
einen Halbleiter-Driftbereich (22) eines ersten Leitungstyps;
einen Halbleiter-Basisbereich (24b) eines zweiten Leitungstyps, der dem ersten Leitungstyp entgegengesetzt ist, wobei der Basis-Bereich an einer Seite an den Drift-Bereich angrenzt; und einen Kollektor-Bereich (20) des zweiten Leitungstyps, der auf einer gegenüberliegenden Seite an den Drift-Bereich angrenzt;einen Halbleiter-Emitter-Bereich (26b) des ersten Leitungstyps, der an den Basis-Bereich angrenzt; und
eine Gate-Elektrode (18a), die isolierend vom Basis-Bereich beabstandet ist und leitend den Drift-Bereich mit dem Emitter-Bereich durch eine aufgrund einer geeigneten Vorspannung im Basisbereich gebildeten Inversionsschicht (24′) koppelt;
die Emitter-, Basis- und Drift-Bereiche bilden zusammen einen ersten inhärenten bipolaren Transistor, während die Kollektor-, Drift- und Basis-Bereiche zusammen einen zweiten inhärenten bipolaren Transistor bilden;
**dadurch gekennzeichnet**,
daß der Emitter-Bereich eine Dotierungsmittelkonzentration an der Oberfläche von zwischen 10¹⁷ und 10¹⁹ Dotiermittelatomen/cm³ und nicht mehr als das 150-fache der Oberflächen-Dotierungsmittelkonzentration des Basis-Bereichs aufweist, derart, daß ein Einrast-Effekt des inhärenten Thyristors verhindert wird. flächen-Dotierungsmittelkonzentration des Basis-Bereichs aufweist, derart, daß ein Einrast-Effekt des inhärenten Thyristors verhindert wird.

2. Isolier-Gate-Transistor nach Anspruch 1, worin
die Dotierungsmittelkonzentration an der Oberfläche des Emitter-Bereiches ist ausreichend, um einen ohmschen Kontakt zwischen dem Emitter-Bereich und einer Emitter-Elektrode (14) zu bewirken, die den Emitter-Bereich kontaktiert.

3. Isolier-Gate-Transistor nach Anspruch 1 oder 2, weiter einschließend:
eine Kollektor-Elektrode (16), die den Kollektorbereich (20) des zweiten Leitungstyps, welcher benachbart zum Drift-Bereich liegt, kontaktiert.

4. Isolier-Gate-Transistor nach Anspruch 1, 2, oder 3, worin:
die Basis-, Emitter- und Driftbereiche bilden eine erste Oberfläche in dem Isolier-Gate-Transistor, wobei sich der Emitter-Bereich in den Basis-Bereich erstreckt und weniger als 1 Mikrometer Tiefe hat.

## Revendications

1. Transistor à porte isolée ayant deux transistors bipolaires inhérents, les transistors étant couplés de manière régénératrice pour former un thyristor inhérent, ce transistor à porte isolée comprenant dans une pastille de semiconducteur au silicium (12) :
une région semiconductrice de glissement (22) d'un premier type de conductivité ;
une région semiconductrice de base (24b) d'un second type de conductivité opposé au premier type de conductivité, cette région de base étant adjointe, sur un côté, à ladite région de glissement, et
une région de collecteur (20) dudit deuxième type de conductivité adjointe à ladite région de glissement sur un côté opposé;
une région semiconductrice d'émetteur (26b) dudit premier type de conductivité adjointe à ladite région de base ; et une électrode de grille (18a) espacée de manière isolée de la région de base et couplant de manière conductrice la région de glissement à la région d'émetteur au moyen d'une couche d'inversion (24′) formée dans la région de base en réponse à l'application d'une polarisation appropriée;
les régions d'émetteur, de base et de glissement constituant ensemble, un premier transistor bipolaire inhérent, cependant que les régions de collecteur, de glissement et de base constituent ensemble un second transistor bipolaire inhérent ;
caractérisé en ce que :
la région d'émetteur a une concentration superficielle en dopant comprise entre 10¹⁷ et 10¹⁹ atomes de dopant par centimètre cube et qui n'est pas supérieure à 150 fois la concentration superficielle en dopant de la région de base afin d'inhiber l'effet de verrouillage du thyristor inhérent.

2. Transistor à porte isolée selon la revendication 1, dans lequel :
ladite concentration superficielle en dopant de la région d'émetteur est suffisante pour établir un contact ohmique entre la région d'émetteur et une électrode d'émetteur (14) en contact avec ladite région d'émetteur.

3. Transistor à porte isolée selon la revendication 1 ou 2, incluant en outre :
une électrode de collecteur (16) en contact avec ladite région de collecteur (20) dudit second type de conductivité adjointe à ladite région de glissement.

4. Transistor à porte isolée selon la revendication 1, 2 ou 3 dans lequel :
lesdites régions de base, d'émetteur, et de glissement forment une première surface dans le transistor à porte isolée avec la région d'émetteur s'étendant dans la région de base et de profondeur inférieure à 1»m.
